# EUROPÄISCHE PATENTSCHRIFT

(11) **EP 2 742 104 B1**
(45) Veröffentlichungstag und Bekanntmachung des Hinweises auf die Patenterteilung: **27.12.2017**
(21) Anmeldenummer: 12735131.0
(22) Anmeldetag: 10.07.2012
(51) Int. Cl.: C09J 9/02, C09J 7/00, H01B 1/22, C09J 5/06, C09J 7/02, C09J 11/04

(54) **ELEKTRISCH LEITFÄHIGE HITZEAKTIVIERBARE KLEBEFOLIE**
ELECTRICALLY CONDUCTIVE HEAT-ACTIVATED ADHESIVE FILM
FILM ADHÉSIF THERMOCOLLANT ÉLECTROCONDUCTEUR

(30) Priorität: 10.08.2011 DE 102011080724
(43) Veröffentlichungstag der Anmeldung: 18.06.2014
(73) Patentinhaber: tesa SE, 22848 Norderstedt (DE)
(72) Erfinder: KEITE-TELGENBÜSCHER, Klaus, 22529 Hamburg (DE)
(86) Internationale Anmeldenummer: PCT/EP2012/063465
(87) Internationale Veröffentlichungsnummer: WO 2013/020765

(56) Entgegenhaltungen:
- EP-A1- 1 541 654
- EP-A1- 2 042 580
- WO-A1-98/39781
- WO-A2-2011/003948
- JP-A- 2001 291 431
- US-A- 5 463 190

## Beschreibung

Die Erfindung betrifft elektrisch leitfähige hitzeaktivierbare Klebefilme mit hervorragender Leitfähigkeit.

Für viele Anwendungen von Kunststoffen in der Elektronik und der Elektrotechnik wird eine elektrische und/oder elektromagnetische und/oder thermische Leitfähigkeit der eingesetzten Komponenten gefordert, auch für die verwendeten Kunststoffteile. Es gibt heute eine Vielzahl von mit leitfähigen Füllstoffen versetzte Kunststoffcompounds, die einen Bereich des spezifischen Durchgangswiderstandes von 10¹⁰ Ω·cm bis 10⁻¹ Ω·cm abdecken. Als elektrisch leitende Füllstoffe werden zum Beispiel Ruß, Kohlefasern, Metallpartikel, Metallfasern oder intrinsisch leitfähige Polymere eingesetzt.

Um einen Isolator wie Kunststoff leitfähig einzustellen, werden über die elektrisch leitfähigen Füllstoffe durchgängige Leitpfade geschaffen, das heißt die leitfähigen Partikel berühren sich im Idealfall. Es ist bekannt, dass sich ein leitendes Netzwerk im Kunststoff am besten mit dem Einbringen von Metall- oder Kohlefasern realisieren lässt. Je länger dabei die Faser ist, desto geringer ist der Gewichtsanteil an Fasern, der für eine bestimmte Leitfähigkeit benötigt wird. Allerdings wird mit zunehmender Faserlänge auch die Verarbeitung problematischer, da die Viskosität des Compounds stark ansteigt. So sind am Markt erhältliche Compounds mit einer Stahlfaserlänge von 10 mm nur bis zu einem maximalen Gewichtsanteil an Fasern von ca. 25 bis 30 % im Spritzgießverfahren verarbeitbar. Mit kürzeren Fasern lassen sich Compounds mit höheren Gewichtsanteilen an Fasern noch im Spritzgießprozess verarbeiten, allerdings bringt dies - im Vergleich zur Langfaser- keine Erniedrigung des spezifischen Durchgangswiderstandes. Ein ähnliches Verhalten gilt für kohlefaser- und metallpartikelgefüllte Thermoplaste.

Ein weiteres Problem ist, dass sich, bedingt durch unterschiedliche Ausdehnungskoeffizienten, das Partikel- oder Fasernetz der gefüllten Thermoplaste bei Temperatureinwirkung weitet und die Leitpfade unterbrochen werden.

Bekannt ist es auch, niedrigschmelzende Metalllegierungen in Polymerschmelzen unter Aufschmelzen dieser Legierungen einzuarbeiten, so dass sich Polymer-Metall-Blends ergeben. Solche Blends werden als spritzgegossene oder extrudierte Leiterbahnen in elektronische Bauteile eingebracht.

So offenbart die US 4,533,685 A Polymer-Metall-Blends, die durch gemeinsames Aufschmelzen von Polymer und niedrigschmelzender Metalllegierung hergestellt werden. Als Polymere werden eine Vielzahl Elastomere, Thermoplaste und härtbare Polymere (Duroplaste) beschrieben, ohne eine bevorzugte Auswahl zu treffen. Ein Hinweis auf die Verwendung als Klebstoff findet sich in dieser Schrift nicht.
Die Polymer-Metall-Blends werden in dieser Schrift zu Presslingen verarbeitet, die eine Dicke von etwa 6 mm besitzen, oder sie werden spritzgegossen. Es wird weiterhin eine Ausführung dargestellt, bei der aus einer Polyurethanmasse eine Folie gezogen wird, wobei die Metalldomänen stark orientiert werden, so dass lediglich eine anisotrope Leitfähigkeit resultiert.
Nachteilig an diesen Systemen ist die Notwendigkeit der Ausbildung eines Blends mit einer kontinuierlichen metallischen Phase, um eine hohe Leitfähigkeit zu erreichen. Dies wird erst bei einem Metallanteil von 50 Vol.-% erreicht. Darunter werden zwar geringere Leitfähigkeiten erreicht, jedoch ist hier die zufällige Ausbildung von Leitpfaden notwendig, so dass das System keinen nennenswerten Vorteil gegenüber partikelgefüllten Systemen bietet.
Liegt eine kontinuierliche Metallphase vor, so nimmt das Material im wesentlichen auch die mechanischen Eigenschaften des Metalls an, was zum Beispiel eine geringe Elastizität und Verformbarkeit bedeutet. Bei Belastung brechen die Metallstrukturen leicht und die Leitfähigkeit sinkt.
Der Zusatz von metallischen Füllstoffen (Pulver, Fasern oder Plättchen) zur Erhöhung der Leitfähigkeit wird allgemein beschrieben, ohne jedoch eine konkrete Auswahl zu treffen.

Die US 4,882,227 A beschreibt eine elektrisch leitfähige Harzmischung, in die eine niedrigschmelzende Metalllegierung sowie leitfähige Fasern eingearbeitet sind. Das Harz wird allerdings oberflächlich auf die Faser-Metall-Mischung beschichtet und dann in Pellets geformt. Somit ist die Oberfläche der Mischung in wesentlichen Teilen nicht leitfähig. Es wird keine isotrop leitfähige Blendstruktur erzeugt.
Die dort verwendeten Polymere sind typische technische Thermoplaste, die der Fachmann in diesem Zusammenhang nicht zur Herstellung von Klebemassen in Erwägung ziehen würde.
Darüber hinaus ist offenbart, dass in dem beschriebenen Harz der Anteil an leitfähigen Fasem 30 Gew.-% nicht übersteigen darf, da ansonsten die Fließfähigkeit und damit die Verarbeitbarkeit des Harzes stark degradiert würden. Dies schränkt die erreichbare Leitfähigkeit ein.
Erst in einem zweiten Schritt werden die erzeugten Pellets als Masterbatch in eine Polymerschmelze aus einem der o.g. Polymere eingebracht und dispergiert. Durch die weitere "Verdünnung" der leitfähigen Komponenten sinkt die Gesamtleitfähigkeit, so dass die Anwendung im Bereich des EMI-Shielding (Abschirmung elektromagnetischer Interferenz) gesehen wird, bei dem eine Leitfähigkeit im Bereich von 10⁻² bis 10² S/cm ausreicht.

Die US 5,554,678 A beschreibt ebenfalls eine für Shielding-Zwecke ausreichend leitfähige Komposition, welche Metallfasern, eine niedrigschmelzende Metalllegierung sowie zusätzlich Kohlenstofffasern enthält. Auch hier werden als Polymer-Basis typische technische Thermoplaste genannt, die der Fachmann nicht zur Herstellung von Klebemassen in Erwägung ziehen würde. Wiederum wird zunächst ein Masterbatch hergestellt und pelletiert. Eine Weiterverarbeitung erfolgt bevorzugt im Spritzgießen. Es wird auch die Verarbeitung durch Spritzguss in Sheets mit anschließender Formgebung beschrieben.

EP 942 436 B1 offenbart eine elektrisch leitende Harzverbindung, enthaltend ein zinkbasiertes Metallpulver, ein niedrig schmelzendes Metall (ausgewählt aus der Gruppe bestehend aus Zinn und aus Zinn-Metalllegierungen, die zum Zeitpunkt eines Formungsvorganges geschmolzen werden), und ein synthetisches Harzmaterial. Im Vergleich zu den oben beschriebenen Schriften werden hier die Metallfasern durch Partikel ersetzt. Dies wird bevorzugt, um die Fließeigenschaften und damit die Verarbeitbarkeit im Spritzgießen zu verbessern. Auch hier wird die Harzverbindung zunächst pelletiert, um dann im Spritzgießverfahren weiterverarbeitet zu werden. Aus diesem Zusammenhang würde der Fachmann diese Schrift nicht zur Herstellung von elektrisch leitfähigen Klebemassen heranziehen. Auf klebende Eigenschaften wird nicht hingewiesen. Die Harze werden ausschließlich zur Herstellung von Formkörpern verwendet.

In der EP 1 695 358 B1 wird ein Metall-Kunststoff-Hybrid vorgeschlagen, das einen Thermoplasten, eine im Bereich zwischen 100 °C und 400 °C schmelzende bleifreie Metallverbindung in einer Menge von 20 bis 50 Gew.-% und Kupferfasern in einer Menge von 30 bis 70 Gew.-% umfasst.
Als Thermoplasten-Komponente enthält das Metall/Kunststoff-Hybrid Massenkunststoffe wie ein Polystyrol (PS) oder Polypropylen (PP), technische Thermoplaste wie Polyamid (PA) oder Polybutylenterephthalat (PBT) oder Hochtemperaturthermoplasten. Auch Blends oder thermoplastische Elastomere werden genannt. Ein Hinweis auf Klebstoffe wird nicht gegeben. Die Hybride werden zum Herstellen von Formkörpern im Spritzgießverfahren verwendet.

Elektrisch leitfähige, hitzeaktivierbare Klebstoffe sind grundsätzlich bekannt.

So wird bei isotrop elektrisch leitfähigen, hitzeaktivierbaren Klebemassen deren Leitfähigkeit durch Füllung mit einem elektrisch leitfähigen Füllstoff bewirkt. Dabei ist der Füllgrad so zu wählen, dass eine Perkolation des Füllstoffs auftritt, also durch geringen Abstand zwischen den Füllstoffpartikeln oder direktem Kontakt Leitpfade für den elektrischen Strom entstehen. Ein Beispiel für dieses Prinzip beschreibt die DE 10 2007 007 617 A.

Bei anisotrop leitfähigen, hitzeaktivierbaren Klebefolien wird die Leitfähigkeit in der Fläche durch verschiedene Maßnahmen verhindert, so dass in der Regel nur eine Leitfähigkeit senkrecht zur Fläche verbleibt. Ein solches Prinzip zeigt beispielweise die DE 10 2004 029 589 A. Weit verbreitet ist die Füllung des Klebstoffs mit einem Füllstoff, dessen Teilchendurchmesser größer als die Schichtdicke der Folie ist, wobei der Füllgrad unterhalb der Perkolationsschwelle bleibt.

Eine weitere Klasse hitzeaktivierbarer leitfähiger Klebefolien ist nur in der Fläche leitfähig, nicht aber senkrecht zur Fläche. Dies wird durch das Einlegen einer leitfähigen Schicht zwischen Schichten aus nicht leitfähigem Klebstoff erreicht.

Insbesondere bei isotrop leitfähigen hitzeaktivierbaren Klebemassen ist das Erreichen einer ausreichend hohen Leitfähigkeit bei gleichzeitig hoher Verklebungsleistung schwierig, da mit zunehmendem Füllgrad die zur Verfügung stehende aktive Verklebungsfläche sinkt. Daher ist es ein gängiges Konzept, den notwendigen Füllgrad durch geschickte Auswahl eines geeigneten Füllstoffs oder einer Kombination von Füllstoffen zu minimieren. Hierzu werden zum Beispiel hochleitfähige Metalle wie Silber, Kupfer oder Gold sowie in ihrem Aspektverhältnis variierte Formen von elektrisch leitfähigen Füllstoffen, wie beispielweise Fasern oder Plättchen (auch im Mikrometer- oder Nanometermaßstab), eingesetzt. Zu nennen sind hier insbesondere Silberfasern, Kupferfasern, silberbeschichtete Micaplättchen oder Schichtsilikate sowie Kohlenstoffnanoröhrchen und Graphen.

Die bestehenden Systeme leitfähiger hitzeaktivierbarer Klebemassen erfordern somit einen Kompromiss zwischen elektrischen Leitfähigkeitseigenschaften und Klebeigenschaften. Aufgabe der Erfindung war es daher, einen im Wesentlichen isotrop leitfähigen, hitzeaktivierbaren Klebemassefilm zur Verfügung zu stellen, der hohe Klebkraft mit hoher elektrischer Leitfähigkeit vereint.

Die Lösung dieser Aufgabe wurde gefunden durch einen hitzeaktiviert verklebbaren Klebemassefilm, der zumindest einen Polymer-Metall-Blend und zumindest einen - insbesondere faserförmigen - elektrisch leitfähigen Füllstoff umfasst. Erfindungsgemäß umfasst der Polymer-Metall-Blend seinerseits zumindest eine hitzeaktiviert verklebbare Klebemasse, die insbesondere eine solche sein kann, wie sie aus dem Stand der Technik an sich bekannt ist, sowie zumindest eine im Temperaturbereich von 50 °C bis 400 °C schmelzende Metallkomponente. Der Füllstoff liegt dabei zumindest teilweise als gebundenes Fasernetzwerk mit der Metallkomponente vor.

"Im Temperaturbereich von 50 °C bis 400 °C schmelzende Metallkomponente" bedeutet, dass für Metallkomponenten mit einem Schmelzpunkt der Schmelzpunkt in dem angegebenen Bereich liegt, für Metallkomponenten - insbesondere Metalllegierungen - mit einem Schmelzbereich die Untergrenze dieses Schmelzbereichs größer oder gleich 50 °C ist und die Obergrenze dieses Schmelzbereichs kleiner oder gleich 400 °C ist. Die Angaben zu Schmelzpunkten und Grenzen des Schmelzbereichs der Metallkomponenten beziehen sich auf die dynamische Messung nach DIN 51004 mit einer Heizrate von 10 °C/min.
"Gebundenes Fasernetzwerk" bedeutet insbesondere, dass die Fasern durch das Metall miteinander verbunden vorliegen und nicht nur sich mechanisch berührend aneinander liegen. Insbesondere können einzelne Teilabschnitte der Fasern in unterschiedliche Bereiche der metallischen Phase eingebunden, z.B. eingeschmolzen, sein, so dass durchgängige Leitungspfade vorliegen.

Überraschend konnten so hitzeaktivierbare Klebefilme hergestellt werden, die bei niedrigem Füllgrad hohe Leitfähigkeit und hohe Verklebungsfestigkeit erlauben.

Ein Vorteil der Erfindung ist, dass die Fasern durch die enthaltene Metallverbindung miteinander kontaktiert werden und somit bereits bei vergleichsweise niedrigen Füllgraden hohe Leitfähigkeiten erreicht werden. Andererseits werden durch den beschriebenen synergistischen Effekt auch bei hohen Füllgraden hohe Verklebungsfestigkeiten erreicht.

Hitzeaktiviert verklebbare Klebemassen (im Folgenden kürzer, aber mit gleicher Bedeutung auch als "hitzeaktivierbare Klebemassen" bezeichnet) sind solche Klebemassen, die durch Zufuhr thermischer Energie (in der Regel bei Überschreitung einer bestimmten Aktivierungstemperatur) aktiviert werden und insbesondere in diesem Zustand zur Anwendung appliziert werden. Bei der Bewirkung der Verklebung ist zwischen zwei Systemen zu unterscheiden: Thermoplastische hitzeaktivierbare Klebstoff-Systeme (Schmelzklebstoffe) binden beim Abkühlen physikalisch ab (in der Regel reversibel), während reaktive hitzeaktivierbare Klebstoff-Systeme (Reaktivsysteme) chemisch abbinden (in der Regel irreversibel). Auch Mischsysteme existieren, also solche Klebemassen, die sich beiden Kategorien zuordnen lassen, nämlich reaktive thermoplastische hitzeaktiviert verklebende Klebemassen (reaktive Schmelzklebstoffe). Die Aktivierungstemperatur von hitzeaktivierbaren Klebemassen lässt sich durch DSC-Messung ermitteln, wobei als Aktivierungstemperatur von thermoplastischen Systemen der Schmelzpunkt, also die Temperatur T_{SP} des Peak-Extremwertes des Schmelzvorgangs, angesehen wird (Messung mittels dynamischer Differenzkalometrie (DSC) gemäß DIN 53765:1994-03 an einer 50 g-Probe, Heizrate 10 °C/min) und für Reaktivsysteme die Temperatur T_{RP} das Peak-Extremwertes der entsprechenden Härtungsreaktion (Messung mittels dynamischer Differenzkalometrie (DSC) gemäß DIN 53765:1994-03 an einer 50 g-Probe, Heizrate 10 °C/min).
Hitzeaktivierbare Klebemassen können bei Raumtemperatur eine gewisse Eigenklebrigkeit ("Tack") aufweisen, dies ist aber nicht zur Bewirkung der Verklebung erforderlich.

Thermoplastische Klebemassen basieren auf Polymeren, die bei einem Erwärmen reversibel erweichen und während des Erkaltens wieder erstarren. Im Gegensatz dazu enthalten reaktive hitzeaktiviert verklebende Klebemassen reaktive Komponenten. Letztere Bestandteile werden auch als "Reaktivharze" bezeichnet, in denen durch das Erwärmen ein Härtungsprozess eingeleitet wird, der nach Beendigen der Härtungsreaktion eine dauerhafte stabile Verbindung auch unter Druck gewährleistet. Häufig sind daher sogenannte Härter zugegen, die mit den Reaktivharzen reagieren können. Bevorzugt enthalten derartige hitzeaktivierbare Klebemassen auch elastische Komponenten, zum Beispiel synthetische Nitrilkautschuke. Derartige elastische Komponenten verleihen der hitzeaktiviert verklebenden Klebemasse infolge ihrer hohen Fließviskosität eine auch unter Druck bei der Applikation besonders hohe Dimensionsstabilität.

Als hitzeaktivierbare Klebemasse für den erfindungsgemäßen Klebefilm lassen sich grundsätzlich alle Systeme hitzeaktivierbarer Klebemassen einsetzen, also thermoplastische hitzeaktivierbare Systeme, Reaktivsysteme sowie Mischsysteme. Insbesondere können auch solche Systeme eingesetzt werden, die bei Raumtemperatur keine Eigenklebrigkeit aufweisen. Sofern Systeme ausgewählt werden, die bei Raumtemperatur und/oder unterhalb der Aktivierungstemperatur eine Eigenklebrigkeit besitzen, kann beispielweise vor der eigentlichen Verklebung durch die Aktivierung der hitzeaktivierbaren Klebemasse eine Vorpositionierung des Klebefilms auf der zu verklebenden Substratoberfläche vorgenommen werden.

Im Folgenden sind rein exemplarisch - und ohne sich hierdurch in der erfindungsgemäßen Lehre beschränken zu wollen - einige typische Systeme hitzeaktiviert verklebender Klebemassen beschrieben, die sich im Zusammenhang mit der vorliegenden Erfindung als besonders vorteilhaft herausgestellt haben.

Eine thermoplastische hitzeaktiviert verklebende Klebemasse enthält also ein thermoplastisches Basispolymer. Dieses weist bereits bei geringem Anpressdruck ein gutes Fließverhalten auf, so dass sich die für die Haltbarkeit einer dauerhaften Verklebung relevante finale Klebkraft innerhalb kurzer Anpresszeit einstellt und daher ein schnelles Verkleben auch auf rauem oder anderweitig kritischem Untergrund möglich ist. Als thermoplastische hitzeaktiviert verklebende Klebemassen können alle aus dem Stand der Technik bekannten thermoplastischen Klebemassen verwendet werden.

Exemplarische Zusammensetzungen sind etwa in EP 1 475 424 A1 beschrieben. So kann die thermoplastische Klebemasse beispielsweise eine oder mehrere der folgenden Komponenten enthalten oder sogar aus diesen bestehen: Polyolefine und deren Copolymere, zum Beispiel Ethylen-Vinylacetat-Copolymere, Ethylen-Ethylacrylat-Copolymere, Polyamide und deren Copolymere, Polyester und deren Copolymere, Polyurethane oder Styrol-Blockcopolymere. Bevorzugt kommen etwa die in Absatz [0027] von EP 1 475 424 A1 aufgeführten thermoplastischen Klebemassen zum Einsatz. Weitere thermoplastische Klebemassen, die insbesondere für spezielle Einsatzgebiete wie zum Beispiel das Verkleben von Verklebungssubstraten aus Glas besonders geeignet sind, sind in EP 1 95 60 63 A2 beschrieben. Bevorzugt werden thermoplastische Klebemassen verwendet, deren Schmelzviskosität durch rheologische Additive heraufgesetzt ist, beispielsweise durch Zusatz von pyrogenen Kieselsäuren, Ruß, Kohlenstoff-Nanoröhren und/oder weiteren Polymeren als Abmischkomponenten. In synergistischer Weise wird diese viskositätserhöhende Funktion auch von dem erfindungsgemäßen Füllstoff übernommen.

Eine reaktive hitzeaktiviert verklebende Klebemasse weist hingegen vorteilhafterweise ein elastomeres Basispolymer und ein Modifikationsharz auf, wobei das Modifikationsharz ein Klebharz und/oder ein Reaktivharz umfasst. Infolge der Verwendung eines elastomeren Basispolymers ist es möglich, Klebeschichten mit hervorragender Dimensionsstabilität zu erhalten. Als reaktive hitzeaktiviert verklebende Klebemassen können entsprechend den jeweiligen konkreten Anwendungen alle aus dem Stand der Technik bekannten hitzeaktiviert verklebenden Klebemassen eingesetzt werden.

Dies beinhaltet zum Beispiel auch reaktive hitzeaktiviert verklebende Folien auf Basis von Nitrilkautschuken oder deren Derivaten wie etwa Nitrilbutadienkautschuke oder Mischungen (Blends) dieser Basispolymere, die zusätzlich Reaktivharze wie etwa Phenolharze enthalten; ein derartiges Produkt ist etwa unter der Bezeichnung tesa 8401 kommerziell erhältlich. Der Nitrilkautschuk verleiht der hitzeaktiviert verklebenden Folie infolge seiner hohen Fließviskosität eine ausgeprägte Dimensionsstabilität, wodurch sich nach Durchführen einer Vernetzungsreaktion hohe Klebkräfte auf Kunststoffoberflächen realisieren lassen.

Weiterhin lassen sich auch andere reaktive hitzeaktiviert verklebende Klebemassen einsetzen wie etwa Klebemassen, die zu einem Masseanteil von 50 bis 95 Gew.-% ein verklebbares Polymer und zu einem Masseanteil von 5 bis 50 Gew.-% ein Epoxidharz oder eine Mischung aus mehreren Epoxidharzen enthalten. Das verklebbare Polymer enthält hierbei vorteilhafterweise zu 40 bis 94 Gew.-% Acrylsäureverbindungen und/oder Methacrylsäureverbindungen der allgemeinen Formel CH₂=C(R¹)(COOR²) (R¹ stellt hierbei einen Rest dar, der ausgewählt ist aus der Gruppe umfassend H und CH₃, und R² stellt einen Rest dar, der ausgewählt ist aus der Gruppe umfassend H und lineare oder verzweigte Alkylketten mit 1 bis 30 Kohlenstoffatomen), zu 5 bis 30 Gew.-% ein erstes copolymerisierbares Vinylmonomer, das zumindest eine Säuregruppe aufweist, insbesondere eine Carbonsäuregruppe und/oder Sulfonsäuregruppe und/oder Phosphonsäuregruppe, zu 1 bis 10 Gew.-% ein zweites copolymerisierbares Vinylmonomer, das zumindest eine Epoxidgruppe oder eine Säureanhydridfunktion aufweist, und zu 0 bis 20 Gew.-% ein drittes copolymerisierbares Vinylmonomer, das zumindest eine funktionelle Gruppe aufweist, die sich von der funktionellen Gruppe des ersten copolymerisierbaren Vinylmonomers und von der funktionellen Gruppe des zweiten copolymerisierbaren Vinylmonomers unterscheidet. Eine derartige Klebemasse ermöglicht ein Verkleben mit einer schnellen Aktivierung, bei der innerhalb kurzer Zeit bereits die finale Klebkraft erreicht wird, so dass hierdurch insgesamt eine gut haftende Verbindung auf unpolarem Untergrund gewährleistet ist.

Eine weitere einsetzbare reaktive hitzeaktiviert verklebende Klebemasse, die besondere Vorteile bietet, enthält zu 40 bis 98 Gew.-% ein acrylathaltiges Blockcopolymer, zu 2 bis 50 Gew.-% eine Harzkomponente und zu 0 bis 10 Gew.-% eine Härterkomponente. Die Harzkomponente enthält eines oder mehrere Harze, die gewählt werden aus der Gruppe umfassend die Klebkraft steigernde (klebrigmachende) Epoxidharze, Novolakharze und Phenolharze. Die Härterkomponente wird zum Vernetzen der Harze aus der Harzkomponente eingesetzt. Eine derartige Formulierung bietet infolge der starken physikalischen Vernetzung innerhalb des Polymers den besonderen Vorteil, dass sich Klebeschichten mit einer größeren Gesamtdicke erhalten lassen, ohne dass dabei die Belastbarkeit der Verklebung insgesamt beeinträchtigt wird. Dadurch sind diese Klebeschichten besonders geeignet, Unebenheiten im Untergrund auszugleichen. Überdies weist eine solche Klebemasse eine gute Alterungsbeständigkeit und ein nur geringes Ausgasungsverhalten auf, was bei vielen Verklebungen im Elektronikbereich besonders erwünscht ist.

Die Auswahl der hitzeaktivierbaren Klebemasse im Zusammenspiel mit der Metallkomponente kann insbesondere im Hinblick auf die gewünschte Anwendung und das eingesetzte Verklebungsverfahren derart geschehen, dass die Aktivierungstemperatur der hitzeaktivierbaren Klebemasse oberhalb der Schmelztemperatur der niedrigschmelzenden Metallkomponente liegt - beziehungsweise für Metallkomponenten mit einem Schmelzbereich oberhalb der oberen Grenze dieses Schmelzbereichs -, oder dass die Aktivierungstemperatur der hitzeaktivierbaren Klebemasse unterhalb der Schmelztemperatur der niedrigschmelzenden Metallkomponente liegt - beziehungsweise für Metallkomponenten mit einem Schmelzbereich unterhalb der unteren Grenze dieses Schmelzbereichs. Natürlich soll hierdurch nicht ausgeschlossen werden, dass die Aktivierungstemperatur der hitzeaktivierbaren Klebemasse und die Schmelztemperatur der niedrigschmelzenden Metallkomponente gerade gleich sind bzw. Metallkomponenten mit einem Schmelzbereich dass die Aktivierungstemperatur im Schmelzbereich der Metallkomponente liegt.

Übergreifend sind hitzeaktivierbare Klebemassen mit einer Wasserdampfpermeation von weniger als 50 g/m²d (ermittelt nach ASTM F-1249 bei 38 °C und 90 % relativer Feuchte bei einer Schichtdicke von 50 µm) zur Verminderung von korrosionsbedingten Leitfähigkeitsverlusten bevorzugt.

Weiterhin bevorzugt sind hitzeaktivierbare Klebemassen mit einem Wassergehalt von weniger als 5000 ppm, insbesondere weniger als 1000 ppm, ermittelt nach 72 h Konditionierung bei 23 °C und 50 % relativer Feuchte mittels Karl-Fischer-Titration (Ausheiztemperatur 150 °C). Solche hitzeaktivierbaren Klebemassen lassen sich beispielsweise in Form polyolefinischer Heißschmelzkleber finden.

Als niedrig schmelzende Metallkomponente lassen sich niedrig schmelzende Metalle, wie beispielweise Zink, Zinn oder prinzipiell auch Blei einsetzen. Insbesondere erfindungsgemäß bevorzugt sind jedoch niedrig schmelzende Metalllegierungen einsetzbar. Die Metallkomponente umfasst im Wesentlichen eines oder mehrere Metalle, kann aber beliebige Zusätze, insbesondere auch nichtmetallische Zusätze und Additive enthalten.

Unter einer niedrig schmelzenden Metalllegierung wird eine metallische Verbindung verstanden, deren Schmelzpunkt bzw. Schmelzbereich zwischen 50 °C und 400 °C, vorzugsweise zwischen 100 °C und 300 °C liegt. Sowohl niedrig schmelzende Metalllegierungen mit einem Schmelzbereich als auch solche mit einem Schmelzpunkt können erfindungsgemäß eingesetzt werden.

Ein Merkmal der niedrig schmelzenden Metalllegierung mit Schmelzpunkt ist ein unmittelbarer und drastischer Viskositätsabfall auf < 50 mPa·s beim Überschreiten des Schmelzpunktes. Diese extrem niedrige, fast wasserähnliche Viskosität trägt im Compound entscheidend zum hohen Fließvermögen bei hohen Füllgraden an Füllstoff bei. Bei einer niedrig schmelzenden Metalllegierung (Lotverbindung) mit einem Schmelzbereich fällt die Viskosität im Schmelzbereich kontinuierlich ab und erreicht erst nach Überschreiten des Schmelzbereichs einen Wert < 50 mPa·s. Erfindungsgemäß können sowohl niedrig schmelzende Metallverbindungen mit einem Schmelzpunkt als auch solche mit einem Schmelzbereich eingesetzt werden. Bevorzugt werden Metalllegierungen mit einem Schmelzbereich, da sich durch den breiteren Temperaturbereich der Erstarrung ein zum Klebstoff ähnlicheres rheologisches Verhalten ergibt, so dass die Extrusion von dünnen Folien, insbesondere deren Verstreckung im Extrusionsprozess erleichtert wird. Solche Metalllegierungen mit einem breiten Schmelzbereich finden sich in der Regel im über- oder untereutektischen Mischungsbereich der Legierung.

Andererseits bevorzugt werden eutektische Legierungen, da hierbei Entmischungserscheinungen geringer ausfallen und weniger Anhaftungen an den Oberflächen der Compoundier- und Ausformungswerkzeuge auftreten.

Bevorzugt werden niedrig schmelzende Metallverbindungen eingesetzt, die frei von Schwermetall, insbesondere solche, die bleifrei sind, also unter toxikologischen Gesichtspunkten unbedenklich sind. Beispielhaft eingesetzte niedrig schmelzende Metallverbindungen enthalten zumindest auch Zinn, Zink und/oder Wismut.

Je nach Anforderung können die Anteile an niedrig schmelzender Metalllegierung und elektrisch leitfähigen Füllstoffen in einem weiten Bereich variiert werden, allgemein in der Summe zwischen 10 bis 99 Gew.-%, insbesondere zwischen 30 und 95 Gew.-% und zwischen 40 und 90 Gew.-%. Zur Erreichung der höchsten Leitfähigkeit hat sich gezeigt, dass der Anteil der niedrig schmelzenden Metalllegierung zwischen 20 und 60 Gew.-%, vorteilhafterweise zwischen 25 und 40 Gew.-% und insbesondere bevorzugt zwischen 27 und 35 Gew.-% liegen sollte. Der Anteil an leitfähigen Füllstoffe(n) beträgt bevorzugt zwischen 20 und 80 Gew.-%, insbesondere bevorzugt zwischen 30 und 70 Gew.-% und insbesondere bevorzugt zwischen 35 und 65 Gew.-%.

Damit können spezifische Durchgangswiderstände von <10⁻³ Ω·cm erreicht werden. Ebenso gut können hohe thermische Leitfähigkeiten > 0,5 W/mK erreicht werden. Die Anforderungen an die Leitfähigkeiten (elektrisch/thermisch) richten sich nach dem Einsatzgebiet des Klebefilms und können in weiten Grenzen variieren. Die Angabe der Leitfähigkeiten soll die Erfindung jedoch in keiner Weise einschränken.

Als elektrisch leitender Füllstoff können alle üblichen und geeigneten Materialien verwendet werden, etwa Aluminium, Kupfer, Silber, Gold, Nickel, Mu-Metall, Alnico, Permalloy, Ferrit, Kohlenstoff-Nanoröhren, Graphen und dergleichen. Günstigerweise weist der elektrisch leitende Füllstoff dabei eine elektrische Leitfähigkeit von mehr als 20 MS/m auf (entsprechend einem spezifischen Widerstand von weniger als 50 mΩ·mm²/m), insbesondere von mehr als 40 MS/m (entsprechend einem spezifischen Widerstand von weniger als 25 mΩ·mm²/m), jeweils bestimmt für 300 K.

Bevorzugt werden Kupfer und Nickel eingesetzt, welche auch lediglich als Beschichtung auf der Oberfläche von anderen Materialien vorliegen können. Diese Metalle zeigen eine bessere Verträglichkeit mit den verwendeten niedrigschmelzenden Metalllegierungen, so dass sich der elektrische Kontakt verbessert. Insbesondere bevorzugt werden verkupferte oder vernickelte Aluminiumfasern, die neben ihrer hohen Leitfähigkeit und der durch die Oberflächenbeschichtung guten Verträglichkeit auch den Vorteil eines geringen Gewichts bieten. Solche Fasern werden zum Beispiel von IKI Global Inc, Korea, angeboten. Weiter bevorzugt werden kupfer- oder nickelbeschichtete Kohlenstofffasern, wie sie z. B. von Sulzer-Metco, Schweiz, unter dem Handelsnamen E-Fill angeboten werden.

Als faserförmig wird der Füllstoff dann angesehen, wenn das Aspektverhältnis, also das Verhältnis zwischen größter Längenausdehnung und dazu orthogonal stehender kleinster Längenausdehnung, mindestens 3, bevorzugt mindestens 10 beträgt.

Für ein dichtes und somit starres Netzwerk, welches der Verformung bei der hitzeaktivierten Verklebung einen hohen Widerstand entgegensetzt und somit das Aufbringen hoher Kontaktierungskräfte ermöglicht, wird eine Faserlänge zwischen 0,1 und 0,9 mm bevorzugt.

Für ein lockeres und somit elastisches Netzwerk, welches den Klebefilm flexibel gestaltet und somit eine Verbesserung der Applizierbarkeit und der Anpassung an gekrümmte Untergründe ermöglicht, wird eine Länge der Faser im Bereich von 1 bis 10 mm bevorzugt.

Je nach Anwendung ist es auch vorteilhaft, ein Gemisch aus zumindest zwei elektrisch leitfähigen Füllstoffen einzusetzen, wobei zumindest einer der elektrisch leitfähigen Füllstoffe faserförmig ist, aber auch zwei oder mehrere der elektrisch leitfähigen Füllstoffe, insbesondere alle elektrisch leitfähigen Füllstoffe faserförmig sein können.

Neben den beschriebenen Inhaltsstoffen des Klebefilms können auch weitere Additive hinzugegeben werden, die die Herstellung des Compounds oder dessen Eigenschaften positiv beeinflussen. Dies können beispielsweise, aber nicht abschließend, Dispergieradditive, Fließhilfsmittel, zum Beispiel Wachse oder Silikone, Verträglichkeitsverbesserer, Haftvermittler, Netzmittel, Lotflussmittel oder intrinsisch leitfähige Polymere sein.

Die Herstellung des Klebefilms kann auf viele dem Fachmann geläufige Arten der Herstellung von Klebefilmen erfolgen. Bevorzugt ist die Herstellung eines schmelzeförmigen Compounds aus hitzeaktivierbarer Klebemasse, Füllstoff und Metalllegierung. Vorteilhafterweise wird das Compound bei einer Temperatur hergestellt und verarbeitet, bei der sowohl die niedrig schmelzende metallische Legierung als auch die Klebemasse in schmelzflüssigem Zustand vorliegen.

Um einen zu starken Anstieg der Viskosität zu verhindern können viskositätsabsenkende Zuschlagstoffe zugesetzt werden, zum Beispiel Wachse.

Die Herstellung des Compounds kann sowohl diskontinuierlich - zum Beispiel in einem Kneter - als auch kontinuierlich - zum Beispiel in einem Extruder, insbesondere vorteilhaft in einem Zweischneckenextruder oder einem kontinuierlichen Kneter, beispielsweise der Fa. Buss (Pratteln/Schweiz) - erfolgen.

Die Herstellung des Klebefilms aus dem Compound kann beispielsweise durch Beschichten, Extrudieren, Walzen, Pressen oder Verstrecken erfolgen.

Der Klebefilm weist vorteilhaft eine Dicke auf, wie sie im Bereich hitzeaktivierbarer Klebefilme üblich ist, also etwa zwischen 1 µm und 1000 µm.
Bevorzugt ist eine Dicke von 10 bis 50 µm, wenn für die Anwendung die Leitfähigkeit innerhalb der Ebene des Klebefilms weniger bedeutsam ist. So kann Material eingespart und die Länge der vom Klebefilm leitfähig zu überbrückenden Distanz klein gehalten werden.
Ist die Leitfähigkeit innerhalb der Ebene von hoher Bedeutung, ist eine Dicke des Klebefilms von 200 bis 500 µm bevorzugt, da hiermit eine größere Querschnittsfläche und somit eine höhere Leitfähigkeit geschaffen wird. Ein bevorzugter Kompromiss zwischen beiden Ausprägungen bildet eine Dicke von 50 bis 200 µm.

Weiterhin kann der Klebefilm einseitig oder beidseitig mit einem Trennliner eingedeckt sein.

In einer besonderen Ausführung kann der Klebefilm mit einer vollflächigen oder durchbrochenen elektrisch leitfähigen Schicht versehen sein. Diese Schicht kann auf zumindest einer Seite des Klebefilms angeordnet sein oder innerhalb des Klebefilms, so dass sich hitzeaktivierbarer Klebstoff auf beiden Seiten der elektrisch leitfähigen Schicht befindet. Eine solche Schicht erhöht vorteilhaft die Leitfähigkeit des Klebefilms innerhalb der Ebene.

Als elektrisch leitende Schicht können alle üblichen und geeigneten Materialien verwendet werden, etwa Aluminium, Kupfer, Silber, Gold, Nickel, Mu-Metall, Alnico, Permalloy, Ferrit, Kohlenstoff-Nanoröhren, Graphen, intrinsisch leitende Polymere, Indium-Zinn-Oxid und dergleichen. Günstigerweise weist die elektrisch leitende Schicht dabei eine elektrische Leitfähigkeit von mehr als 20 MS/m auf (entsprechend einem spezifischen Widerstand von weniger als 50 mΩ·mm2/m), insbesondere von mehr als 40 MS/m (entsprechend einem spezifischen Widerstand von weniger als 25 mΩ·mm2/m), jeweils bestimmt für 300 K.

Die Schicht liegt vorteilhaft in durchbrochener Form vor, etwa als Stanzgitter, Drahtgeflecht, Streckmetall, Vlies oder als gedrucktes oder mit anderen üblichen Verfahren, auch mit Vakuumverfahren wie Bedampfen, abgeschiedenes Muster.

Die Form des hitzeaktivierbaren Klebefilms kann bahnförmig oder blattförmig sein. Insbesondere kann dabei die Form an die Geometrie der Verklebungsfläche angepasst sein, so dass der Klebefilm etwa als Zuschnitt oder Stanzling vorliegt. Dies bedeutet insbesondere, dass die Form in etwa oder exakt der Form der Verbindungsflächen der zu verbindenden Bauteile und somit der lateralen Form der Klebefuge entspricht. Typischerweise sind bei solchen Flächenelementen die Anforderungen an Formstabilität und Verklebungsfestigkeit besonders hoch.

Für Anwendungen, in denen keine isotrope Leitfähigkeit gefordert wird, ist es vorteilhaft, die Fasern und/oder die durch die Metalllegierung gebildeten Bereiche (z.B. Partikel) entsprechend der gewünschten Vorzugsrichtung auszurichten. Dies kann zum Beispiel durch Verstreckung bei der Extrusion von erfindungsgemäßen Klebefilmen erreicht werden. Hierdurch ergibt sich eine höhere Leitfähigkeit in der Ebene des hitzeaktivierbaren Klebefilms. Bei der Verwendung magnetischer Fasern, zum Beispiel aus Nickel oder nickelbeschichteten Werkstoffen, ist es besonders vorteilhaft möglich, die Fasern mittels eines Magnetfeldes während des thermischen Aktivierungsvorgangs auszurichten. Durch die erniedrigte Viskosität bei diesem Vorgang kann eine solche Ausrichtung erfolgen und wird nach Beendigung der Aktivierung festgehalten. Besonders vorteilhaft ist eine Ausrichtung im Wesentlichen senkrecht zur Ebene des Klebemassefilms, da hierdurch eine verbesserte Kontaktierung der zu verklebenden Substrate erreicht wird. Die erforderlichen Magnete können dafür leicht in die Werkzeuge einer Klebepresse eingebracht werden. Besonders vorteilhaft ist für diese Verfahren die Verwendung von magnetisch beschichteten Kohlenstofffasern, da diese sich durch ihre hohe Steifigkeit leichter ausrichten lassen.

Gegenstand der Erfindung ist weiterhin ein Verfahren zum Verkleben eines Klebefilms auf einer Substratoberfläche sowie weiterhin ein Verfahren zum Verkleben zweier Substratflächen miteinander (die zwei unterschiedlichen Fügepartnern zugeordnet sein können, aber auch zu einem einzigen Fügepartner mit entsprechend angeordneten zu verklebenden Flächen gehören können) mittels eines Klebefilms. Bei diesen Verfahren wird jeweils die Verklebung mittels eines hitzeaktiviert verklebbaren Klebefilms bewirkt, der zumindest einen Polymer-Metall-Blend und zumindest einen faserförmigen elektrisch leitfähigen Füllstoff umfasst, wobei der Polymer-Metall-Blend seinerseits zumindest eine hitzeaktiviert verklebbare Klebemasse sowie zumindest eine im Temperaturbereich von 50 °C bis 400 °C schmelzende Metallkomponente umfasst, und wobei der Füllstoff zumindest teilweise im Hybrid mit der Metallkomponente vorlegt.
Der Klebefilm ist dabei insbesondere ein solcher Klebefilm, wie er im Rahmen dieser Schrift beschrieben wurde und/oder wie er sich aus einem der Ansprüche ergibt.

Bevorzugt wird ein Verfahren zum Verkleben des hitzeaktivierbaren Klebefilms eingesetzt, bei dem die Aktivierung bei einer Temperatur oberhalb der Schmelztemperatur der Metalllegierung vorgenommen wird (bei dem also die Aktivierungstemperatur der hitzeaktivierbaren Klebemasse oberhalb der Schmelztemperatur der niedrigschmelzenden Metallkomponente liegt). Überraschend wird durch die niedrigschmelzende Metallkomponente während der Hitzeaktivierung ein lotähnlicher Kontakt zum zu kontaktierten Substrat hergestellt, welcher den elektrischen Übergang im Vergleich zu lediglich berührenden Partikeln erheblich verbessert und zudem synergistisch zur Festigkeit der Verbindung beiträgt, so dass eine Festigkeit erreicht wird, die oberhalb der aufgrund der Benetzungsfläche des hitzeaktivierbaren Klebstoffs zu erwartenden Verklebungsfestigkeit liegt.

Kann oder soll keine lotartige Verbindung der Metallverbindung mit dem zu kontaktierenden Substrat zustande kommen, ist es vorteilhaft, die Aktivierungstemperatur der hitzeaktivierbaren Klebemasse unterhalb der Schmelztemperatur der Metallkomponente zu wählen. Beim hitzeaktivierten Fügen unter Aufbringen einer Andruckkraft wird dann das Fasernetzwerk elastisch und/oder plastisch komprimiert und somit in innigen Kontakt zum Substrat gebracht. Im Gegensatz zu lediglich verteilt im Klebstoff vorliegenden leitfähigen Füllstoffen, die beim Fügevorgang mit der erweichenden Polymermatrix fließen, wird das Netzwerk verformt und baut so einen Kontaktierungsdruck auf, der zu einer verbesserten und dauerhafteren Kontaktierung des Substrats führt.

In einem weiteren vorteilhaften Verfahren wird zunächst ein Vorverbund des Klebefilms mit einem der Fügepartner gebildet. Dazu wird der Klebefilm in Kontakt mit der zu verklebenden Oberfläche des Fügepartners gebracht und vorteilhaft nur eine Hitzeaktivierung bis unterhalb der Schmelztemperatur der Metalllegierung verwendet. Hierdurch kann zum Beispiel ein vorgeformter Klebebandabschnitt auf einem Fügeteil vorfixiert werden. Erst bei der finalen Verklebung mit dem Fügepartner - oder zwischen den beiden zu verklebenden Fügepartnern - wird dann eine Hitzeaktivierung oberhalb der Schmelztemperatur der Metalllegierung verwendet, so dass sich die volle Festigkeit und elektrische Leitfähigkeit der Verklebung einstellt.

Der erfindungsgemäße Artikel und die Verfahren werden bevorzugt zum Verkleben von Baueinheiten elektronischer Geräte eingesetzt, etwa solche aus dem Bereich der Konsumgüterelektronik, Unterhaltungselektronik oder Kommunikationselektronik (zum Beispiel für Mobiltelefone, PDAs, Laptops und andere Rechner, Digitalkameras und Anzeigegeräte wie etwa Displays, Digitalreader oder organische Leuchtdiodendisplays (OLEDs)) sowie für Solarzellenmodule wie etwa Siliziumsolarzellen, elektrochemische Farbstoff-Solarzellen, organische Solarzellen oder Dünnschichtzellen) oder elektrochemische Zellen, wie zum Beispiel Elektrolysezellen oder Brennstoffzellen. Als Baueinheiten werden vorliegend alle Bestandteile und Ansammlungen derselben verstanden, die in elektronischen Geräten verwendet werden, beispielsweise elektronische Bauteile (diskrete und integrierte Bauelemente), Gehäuseteile, elektronische Module, Antennen, Anzeigefelder, Schutzscheiben, unbestückte und/oder bestückte Platinen und dergleichen.

### Beispiele:

Für Verklebungen mit dem erfindungsgemäßen Flächenelement wurden in einer Heizpresse der Fa. Bürkle bei einem Druck von 0,2 MPa und der jeweils im Beispiel angegebenen Aktivierungstemperatur zwei 1,5 mm dicke Messingbleche mittels eines 100 µm dicken Klebefilms miteinander verklebt. Die Aktivierungszeit wurde jeweils so gewählt, dass ein Aufschmelzen des Klebefilms zu beobachten war, jedoch kein übermäßiges Ausquetschen aus der Klebefuge.

Als Kenngröße für die Qualität der erzielten Verklebung wurde die Verklebungsfestigkeit des so erhaltenen Verbunds für unterschiedliche hitzeaktiviert verklebbare Flächenelemente und unterschiedliche Verfahrensparameter ermittelt. Hierzu wurde die Verklebungsfestigkeit in einem dynamischen Zugscherversuch entsprechend DIN 53283 bei 23 °C für eine Prüfgeschwindigkeit von 1 mm/min jeweils quantitativ bestimmt (Ergebnisse in N/cm²). Angegeben ist der Mittelwert aus drei Messungen.

Zur Messung der elektrischen Leitfähigkeit wurden bei der Verklebung anstelle der Messingbleche 50 µm dicke Messingfolien verwendet und aus dem so erhaltenen Klebeverbund runde Prüfkörper mit einer Fläche von 6,45 cm² angefertigt. Die Messung des Durchgangswiderstands erfolgte bei Raumtemperatur (23 °C) und 50 % relativer Luftfeuchte analog zu ASTM D 2739 mit einem Anpressdruck der Elektroden von 76 kPa. Angegeben ist der Mittelwert aus drei Messungen.

Als hitzeaktivierbare Klebstoffe wurden verwendet:
- Klebstoff 1: Grilltex 1365 (Copolyester) der Fa. Ems-Chemie
- Klebstoff 2: Amplify EA 100 (Ethylen-Copolymer) der Fa. Dow Chemical
- Klebstoff 3: Irostic 8304 HV (thermoplastisches Polyurethan) der Fa. Huntsman
- Klebstoff 4: Yparex 8102E (Ethylen-Copolymer) der Fa. DSM
- Klebstoff 5: Platamid 2395 (Copolyamid) der Fa. Arkema

Als faserförmige Füllstoffe wurden verwendet:
- Faser 1: Kupferfaser F08 (0,8 mm lang, 60 µm dick) der Fa. Deutsches Metallfaserwerk, Neidenstein
- Faser 2: Kupferfaser F3 (3 mm lang, 180 µm dick) der Fa. Deutsches Metallfaserwerk, Neidenstein

Als niedrigschmelzende Metalllegierungen wurden verwendet:
- Metall 1: MCP 200 (Schmelzpunkt 199 °C) der Fa. HEK, Lübeck
- Metall 2: MCP 62 (Schmelzpunkt 60 °C) der Fa. HEK, Lübeck
- Metall 3: MCP 150 (Schmelzbereich 138 - 170 °C) der Fa. HEK, Lübeck

Folgende Compounds wurden hergestellt (Mengenangaben in Gew.-%):

| Beispiel | Klebstoff | | | | | Faser | | Metall | | |
|---|---|---|---|---|---|---|---|---|---|---|
| | [Gew.-%] | | | | | [Gew.-%] | | [Gew.-%] | | |
| | 1 | 2 | 3 | 4 | 5 | 1 | 2 | 1 | 2 | 3 |
| 1 | 40 | | | | | 20 | | 40 | | |
| 2 | 20 | | | | | 20 | | 60 | | |
| 3 | 25 | | | | | 35 | | 40 | | |
| 4 | 5 | | | | | 35 | | 60 | | |
| 5 | 32,5 | | | | | 27,5 | | 40 | | |
| 6 | 12,5 | | | | | 27,5 | | 60 | | |
| 7 | 30 | | | | | 20 | | 50 | | |
| 8 | 15 | | | | | 35 | | 50 | | |
| 9 | 22,5 | | | | | 27,5 | | 50 | | |
| 10 | 15 | | | | | 40 | | 45 | | |
| 11 | 15 | | | | | 45 | | 40 | | |
| 12 | 15 | | | | | 50 | | 35 | | |
| 13 | | 15 | | | | 40 | | 45 | | |
| 14 | | | 15 | | | 40 | | 45 | | |
| 15 | | | | 15 | | 40 | | 45 | | |
| 16 | | | | | 15 | 40 | | 45 | | |
| 17 | 15 | | | | | | 40 | 45 | | |
| 18 | 15 | | | | | | 45 | 40 | | |
| 19 | 15 | | | | | | 35 | 50 | | |
| 20 | 15 | | | | | 40 | | | 45 | |
| 21 | 15 | | | | | 40 | | | | 45 |
| V1 | 15 | | | | | 85 | | | | |
| V2 | | 15 | | | | | | | | 85 |

Die Compounds wurden mit einem gleichläufigen Zweischneckenextruder ZSK25 der Fa. Coperion mit einem Verhältnis L/d von 40 hergestellt. Die Temperaturführung wurde jeweils so gewählt, dass Klebstoff und Metalllegierung vollständig aufgeschmolzen wurden. In einer ersten Verfahrenszone wurde ein Blend aus Klebstoff und Metalllegierung hergestellt; zu welchem in einer zweiten Verfahrenszone die Metallfasern hinzugegeben wurden. Zur Ausformung des erfindungsgemäßen Klebefilms wurde direkt an den Extruder eine Flachfoliendüse angeflanscht und eine Flachfolie in der Dicke von 200 µm extrudiert.

Überraschenderweise stellte sich heraus, dass im Extrusionsverfahren wesentlich höhere Faseranteile verarbeitet werden konnten, als im Stand der Technik bekannt war.

Vergleichsbeispiel 1 wurdeabweichend in einem Messkneter der Fa. Haake hergestellt, da sich die entsprechende Formulierung nicht mehr extrudieren ließ. Aus dem so hergestellten Compound wurden in einer Vakuumpresse der Fa. Laufer Presslinge mit einer Dicke von 200 µm hergestellt.

Die Verklebungsfestigkeiten sowie die elektrische Leitfähigkeiten sind in folgender Tabelle dargestellt:

| Beispiel | Aktivierungstemperatur | Verklebungsfestigkeit | Durchgangswiderstand |
|---|---|---|---|
| | [°C] | [N/cm²] | [Ωcm] |
| 1 | 130 | 452 | 2,92E-02 |
| 2 | 130 | 286 | 2,38E-03 |
| 3 | 130 | 291 | 2,36E-03 |
| 4 | 130 | 181 | 1,21E-05 |
| 5 | 130 | 409 | 9,70E-03 |
| 6 | 130 | 226 | 3,31E-04 |
| 7 | 130 | 375 | 9,74E-03 |
| 8 | 130 | 286 | 3,29E-04 |
| 9 | 130 | 320 | 2,37E-03 |
| 10 | 130 | 289 | 2,15E-04 |
| 11 | 130 | 299 | 1,35E-04 |
| 12 | 130 | 294 | 3,34E-04 |
| 13 | 110 | 245 | 1,02E-04 |
| 14 | 150 | 239 | 3,82E-04 |
| 15 | 150 | 252 | 8,91E-04 |
| 16 | 130 | 545 | 1,37E-04 |
| 17 | 130 | 312 | 1,20E-03 |
| 18 | 130 | 325 | 3,01E-03 |
| 19 | 130 | 310 | 9,64E-04 |
| 20 | 130 | 433 | 4,15E-04 |
| 21 | 130 | 342 | 9,98E-04 * |
| 21a | 170 | 417 | 3,27E-04 |
| V1 | 130 | 331 | 7,26E-1 |
| V2 | 110 | 228 | 1,55E1 |

| | | | |
|---|---|---|---|
| * glatte Folienoberfläche | | | |

Die Beispiele zeigen, dass die erfindungsgemäßen Klebefilme mit gebundenem Fasernetzwerk gegenüber den lediglich mit Fasern oder Partikeln gefüllten Vergleichsbeispielen deutlich erhöhte Leitfähigkeiten zeigen. Der Effekt ist bei verschiedenen Klebstoffpolymeren zu beobachten.

Eine Erhöhung des Faseranteils führt bei gleichbleibendem Gesamtfüllstoffgehalt in der Tendenz zu höheren Leitfähigkeiten und leicht erhöhten Verklebungsfestigkeiten, was auf die höhere Leitfähigkeit der Fasern und die größere Flexibilität des Netzwerks zurückgeführt wird.

Ist der Anteil der niedrigschmelzenden Metalllegierung geringer, nimmt die Leitfähigkeit wieder ab, da wahrscheinlich die Ausprägung des Netzwerkes aus Fasern und Bereichen der metallischen Phase abnimmt (Beispiel 12).

Längere Fasern erniedrigen die Leitfähigkeit, was auf die höhere Orientierung in die Ebene des extrudierten Films zurückgeführt wird. Daraus ist auf eine Erhöhung der Leitfähigkeit in der Ebene zu schließen (Beispiele 17 - 19).

Mit den bei niedrigeren Temperaturen schmelzenden Metalllegierungen geht ein Verlust an Leitfähigkeit einher, was aber ausschließlich auf die geringere Leitfähigkeit dieser Legierungen selbst zurückgeführt wird.
In den Beispielen 20 und 21a, bei denen die niedrigschmelzende Metalllegierung bei der Aktivierungstemperatur aufschmilzt, tritt der synergistische Effekt der gleichzeitigen Festigkeitserhöhung der Verklebung und Leitfähigkeitserhöhung auf. Dies wird auf eine verbesserte Kontaktierung des Substratmaterials zurückgeführt.

## Patentansprüche

1. Hitzeaktiviert verklebbarer Klebefilm,
umfassend
a) einen Polymer-Metall-Blend umfassend
- zumindest eine hitzeaktiviert verklebbare Klebemasse,
- zumindest eine im Temperaturbereich von 50 °C bis 400 °C schmelzende Metallkomponente,
b) zumindest einen faserförmigen elektrisch leitfähigen Füllstoff,
wobei der Füllstoff zumindest teilweise als verbundenes Fasernetzwerk mit der Metallkomponente vorliegt.

2. Klebefilm nach Anspruch 1, **dadurch gekennzeichnet, dass** die Metallkomponente ein Metall oder eine Metalllegierung ist.

3. Klebefilm nach einem der vorangehenden Ansprüche, **dadurch gekennzeichnet, dass**
die hitzeaktiviert verklebbare Klebemasse ein hitzeaktivierbarer thermoplastischer Klebstoff ist.

4. Klebefilm nach einem der vorangehenden Ansprüche, **dadurch gekennzeichnet, dass**
die hitzeaktiviert verklebbaren Klebemasse ein hitzeaktivierbarer Reaktivklebstoff ist.

5. Klebefilm nach einem der vorangehenden Ansprüche, **dadurch gekennzeichnet, dass**
zumindest einer der der elektrisch leitfähigen Füllstoffe metallisch ist.

6. Klebefilm nach einem der vorangehenden Ansprüche, **dadurch gekennzeichnet, dass**
zumindest einer der elektrisch leitfähigen Füllstoffe eine Kohlenstoffmodifikation oder eine Kohlenstoff enthaltende chemische Verbindung ist.

7. Klebefilm nach zumindest einem der vorangehenden Ansprüche, **dadurch gekennzeichnet, dass**
zumindest einer der elektrisch leitfähigen Füllstoffe magnetisch ist.

8. Verfahren zum Verkleben auf einer Substratoberfläche, **dadurch gekennzeichnet, dass**
die Verklebung mittels eines hitzeaktiviert verklebbaren Klebefilms nach einem der vorangehenden Ansprüche bewirkt wird.

9. Verfahren nach Anspruch 8, **dadurch gekennzeichnet, dass** zwei Substratoberflächen mittels des hitzeaktiviert verklebbaren Klebefilms miteinander verklebt werden.

10. Verfahren nach einem der Ansprüche 8 bis 9, **dadurch gekennzeichnet, dass** die Aktivierung des hitzeaktiviert verklebbaren Klebefilms bei einer Temperatur oberhalb der Schmelztemperatur der Metallkomponente vorgenommen wird.

11. Verfahren nach einem der Ansprüche 8 bis 10, **dadurch gekennzeichnet, dass**
- zunächst eine Vorfixierung des Klebefilms auf einer der Substratoberflächen bewirkt wird, indem der Klebefilm bei einer Temperatur unterhalb der Schmelztemperatur der Metallkomponente aktiviert wird,
- danach die Endfixierung bewirkt wird, indem der Klebefilm auf der Substratoberfläche beziehungsweise in seiner endlich vorliegenden Anordnung zwischen den beiden Substratoberflächen bei einer Temperatur oberhalb der Schmelztemperatur der Metallkomponente aktiviert wird.

12. Verfahren nach einem der Ansprüche 8 - 11, **dadurch gekennzeichnet, dass** die Verklebung mittels eines hitzeaktiviert verklebbaren Klebefilms nach Anspruch 7 bewirkt wird und der Füllstoff vor oder während der Aktivierung mittels eines Magnetfelds ausgerichtet wird.

## Claims

1. Adhesive film which can be bonded when heat-activated comprising
a) a polymer-metal blend comprising
- at least one adhesive which can be bonded when heat-activated,
- at least one metal component melting in the temperature range from 50°C to 400°C,
b) at least one fibrous, electrically conductive filler, the filler being present at least partly in the form of a bound fiber network with the metal component.

2. Adhesive film according to Claim 1, **characterized in that** the metal component is a metal or a metal alloy.

3. Adhesive film according to either of the preceding claims, **characterized in that** the adhesive which can be bonded when heat-activated is a heat-activatable thermoplastic adhesive.

4. Adhesive film according to any of the preceding claims, **characterized in that** the adhesive which can be bonded when heat-activated is a heat-activatable reactive adhesive.

5. Adhesive film according to any of the preceding claims, **characterized in that** at least one of the electrically conductive fillers is metallic.

6. Adhesive film according to any of the preceding claims, **characterized in that** at least one of the electrically conductive fillers is a carbon modification or a carbon-containing chemical compound.

7. Adhesive film according to at least one of the preceding claims, **characterized in that** at least one of the electrically conductive fillers is magnetic.

8. Method for adhesive bonding on a substrate surface, **characterized in that** the bonding is produced by means of an adhesive film which can be bonded when heat-activated according to any of the preceding claims.

9. Method according to Claim 8, **characterized in that** two substrate surfaces are bonded to one another by means of the adhesive film which can be bonded when heat-activated.

10. Method according to either of Claims 8 and 9, **characterized in that** the activation of the adhesive film which can be bonded when heat activated is performed at a temperature below the melting temperature of the metal component.

11. Method according to any of Claims 8 to 10, **characterized in that**
- first of all the adhesive film is subjected to preliminary fastening on one of the substrate surfaces, by the adhesive film being activated at a temperature below the melting temperature of the metal component;
- thereafter the final fixing is brought about, by the adhesive film being activated on the substrate surface, or in its ultimate disposition between the two substrate surfaces, at a temperature above the melting temperature of the metal component.

12. Method according to any of Claims 8 - 11, **characterized in that**
the adhesive bonding is brought about by means of an adhesive film which can be bonded when heat-activated, according to Claim 7, and the filler is oriented by means of a magnetic field before or during the activation.

## Revendications

1. Film adhésif pouvant être collé par activation thermique, comprenant
a) un mélange polymère-métal, comprenant
- au moins une masse adhésive pouvant être collée par activation thermique,
- au moins un composant métallique fusible dans la plage de température de 50°C à 400°C,
b) au moins une charge électroconductrice sous forme de fibres,
la charge se trouvant au moins partiellement sous forme de réseau fibreux assemblé avec le composant métallique.

2. Film adhésif selon la revendication 1, **caractérisé en ce que** le composant métallique est un métal ou un alliage métallique.

3. Film adhésif selon l'une quelconque des revendications précédentes, **caractérisé en ce que** la masse adhésive pouvant être collée par activation thermique est un adhésif thermoplastique pouvant être thermiquement activé.

4. Film adhésif selon l'une quelconque des revendications précédentes, **caractérisé en ce que** la masse adhésive pouvant être collée par activation thermique est un adhésif réactif pouvant être thermiquement activé.

5. Film adhésif selon l'une quelconque des revendications précédentes, **caractérisé en ce qu'**au moins une des charges électroconductrices est métallique.

6. Film adhésif selon l'une quelconque des revendications précédentes, **caractérisé en ce qu'**au moins une des charges électroconductrices est une modification du carbone ou un composé chimique contenant du carbone.

7. Film adhésif selon au moins l'une quelconque des revendications précédentes, **caractérisé en ce qu'**au moins une des charges électroconductrices est magnétique.

8. Procédé pour le collage sur une surface de substrat, **caractérisé en ce que** le collage est effectué au moyen d'un film adhésif pouvant être collé par activation thermique selon l'une quelconque des revendications précédentes.

9. Procédé selon la revendication 8, **caractérisé en ce que** deux surfaces de substrat sont collées l'une à l'autre au moyen du film adhésif pouvant être collé par activation thermique.

10. Procédé selon l'une quelconque des revendications 8 à 9, **caractérisé en ce que** l'activation du film adhésif pouvant être collé par activation thermique est réalisée à une température supérieure à la température de fusion du composant métallique.

11. Procédé selon l'une quelconque des revendications 8 à 10, **caractérisé en ce que**
- un préfixation du film adhésif sur une des surfaces de substrat est d'abord réalisée, **en ce que** le film adhésif est activé à une température inférieure à la température de fusion du composant métallique,
- une fixation finale est réalisée ensuite, **en ce que** le film adhésif sur la surface de substrat, ou, selon le cas, dans sa disposition finale entre les deux surfaces de substrat est activé à une température supérieure à la température de fusion du composant métallique.

12. Procédé selon l'une quelconque des revendications 8-11, **caractérisé en ce que** le collage est réalisé au moyen d'un film adhésif pouvant être collé par activation thermique selon la revendication 7 et la charge est orientée avant ou pendant l'activation au moyen d'un champ magnétique.
